# EUROPÄISCHE PATENTSCHRIFT

(11) **EP 2 132 582 B1**
(45) Veröffentlichungstag und Bekanntmachung des Hinweises auf die Patenterteilung: **22.09.2010**
(21) Anmeldenummer: 08717263.1
(22) Anmeldetag: 29.02.2008
(51) Int. Cl.: G01R 31/30, G01R 31/317

(54) **VERFAHREN ZUR BESTIMMUNG EINER ASYMMETRISCHEN SIGNALVERZÖGERUNG EINES SIGNALPFADES INNERHALB EINER INTEGRIERTEN SCHALTUNG**
METHOD FOR DETERMINING ASYMMETRICAL SIGNAL LAG OF A SIGNAL PATH INSIDE AN INTEGRATED CIRCUIT
PROCÉDÉ DE DÉTERMINATION D'UN RETARD DE SIGNAL ASYMÉTRIQUE D'UNE VOIE DE SIGNAL DANS UN CIRCUIT INTÉGRÉ

(30) Priorität: 06.03.2007 DE 102007010771
(43) Veröffentlichungstag der Anmeldung: 16.12.2009
(73) Patentinhaber: Robert Bosch GmbH, 70442 Stuttgart (DE)
(72) Erfinder: ROHATSCHEK, Andreas-Juergen, 73249 Wernau/neckar (DE)
(86) Internationale Anmeldenummer: PCT/EP2008/052482
(87) Internationale Veröffentlichungsnummer: WO 2008/107380

(56) Entgegenhaltungen:
- DE-A1-102005 060 903
- US-A1- 2002 026 610
- US-A1- 2005 028 050

## Beschreibung

Die vorliegende Erfindung betrifft ein Verfahren zur Bestimmung der asymmetrischen Signalverzögerung eines Signalpfades innerhalb einer integrierten Schaltung und insbesondere ein Verfahren zur Bestimmung der asymmetrischen Signalverzögerung eines Signalpfades innerhalb eines Kommunikationskontrollbausteins bei einem FlexRay-Bus.

Bei einem FlexRay-Bus-System erfolgt die Übertragung von Daten über eine Vielzahl von Bauelementen, die jeweils eine asymmetrische Verzögerung von Signalflanken aufweisen. Bei den Bauelementen handelt es sich beispielsweise um aktive Sterne, Transceiver, Eingangs- und Ausgangspuffer.

Die asymmetrische Signalverzögerung eines Bauelementes ist der Unterschied zwischen der Durchlaufverzögerung einer steigenden und der Durchlaufverzögerung einer fallenden Signalflanke durch das Bauelement. Dabei können die Ursachen der asymmetrischen Verzögerungen in systematische und unsystematische Anteile unterteilt werden. Die systematischen Ursachen für eine asymmetrische Verzögerung eines Bauelements sind bei einem vorgegebenen Betriebspunkt, beispielsweise einer bestimmten Temperatur oder eine bestimmte Versorgungsspannung, für das Bauelement innerhalb spezifizierter Toleranzgrenzen fest vorgegeben. Eine maximal zulässige asymmetrische Signalverzögerung wird bei einer Datenübertragung durch das jeweilige Datenübertragungsprotokoll festgelegt. Ein Datenübertragungsprotokoll gibt beispielsweise vor, dass eine nominale Bitdauer n-fach abgetastet wird und bei einem vorgegebenen Abtastzählerstand der abgetastete Wert zur weiteren Datenverarbeitung übernommen wird. Die Datenverarbeitung besteht beispielsweise aus der Dekodierung eines seriellen Datenstroms. Bei dem Datenübertragungsprotokoll des FlexRay-Busses wird beispielsweise die nominale Bitdauer achtfach abgetastet und der abgetastete logische Wert bei einem Abtastzählerstand von fünf übernommen. Bei dem FlexRay-Datenübertragungsprotokoll werden maximal 37,5 nsec. asymmetrische Verzögerung in dem

Übertragungskanal für eine fehlerfreie Dekodierung erlaubt. Wird die maximal zulässige asymmetrische Verzögerung überschritten, kann ein falscher Bitwert abgetastet werden. Der fehlerhafte Bitwert wird beispielsweise über einen Cyclic Redundancy-Check (CRC) erkannt und die empfangenen Daten werden entweder verworfen oder mit zusätzlichem Aufwand in der Software nochmals übertragen.

Bei der Auslegung eines Bussystems müssen alle eine Asymmetrie verursachenden Bauelemente in der Wirkungskette ausgehend von einem sendenden Bauelement hin zu einem empfangenden Bauelement berücksichtigt werden. Dazu werden herkömmlicherweise die einzelnen Asymmetriebeiträge aus Datenblättern und Abschätzungen entnommen und aufsummiert.

Bei integrierten Schaltungen ist es allerdings nicht möglich, die durch einen integrierten Signalpfad hervorgerufene asymmetrische Verzögerungen zu bestimmen, da kein Messsignal an einem Messpunkt abgegriffen werden kann. Ein zusätzliches Testsignal-Pad zum Abgriff eines derartigen Messsignals stellt einen nicht-rechtfertigbaren zusätzlichen technischen Aufwand dar. Darüber hinaus sind die in dem Gehäuse der integrierten Schaltung vorgesehenen Signal-Pads bereits in den meisten Fällen belegt.

Die US 2005/028050 (Olivier Ganry, 03.02.2005) beschreibt ein Verfahren zur Bestimmung der Signalverzögerung einer steigender oder einer fallender Signalflanke eines Signalpfades in einer integrierten Schaltung.

Es ist daher die Aufgabe der vorliegenden Erfindung, ein Verfahren zur Bestimmung von asymmetrischen Signalverzögerungen eines Signalpfades innerhalb einer integrierten Schaltung zu schaffen, bei dem die asymmetrische Signalverzögerung ohne Vorsehen eines zusätzlichen Signal-Pads bestimmt werden kann.

Diese Aufgabe wird erfindungsgemäß durch ein Verfahren mit den im Patentanspruch 1 angegebenen Merkmalen gelöst.

Die Erfindung schafft ein Verfahren zur Bestimmung einer asymmetrischen Signalverzögerung und/oder Jitters eines Signalpfades innerhalb einer integrierten Schaltung mit den folgenden Schritten:
- Auskoppeln eines von dem Signalpfad abgegebenen Signal mittels eines integrierten Multiplexers zur Messung einer asymmetrischen Signalverzögerung eines Messpfades, der durch den integrierten Signalpfad und durch den integrierten Multiplexer gebildet wird;
- Messen der asymmetrischen Signalverzögerung des integrierten Multiplexers; und
- Berechnen einer Differenz zwischen der asymmetrischen Signalverzögerung des Messpfades und der asymmetrischen Signalverzögerung des integrierten Multiplexers zur Bestimmung der asymmetrischen Signalverzögerung des Signalpfades.

Bei einer Ausführungsform des erfindungsgemäßen Verfahrens legt ein externes Messgerät zur Messung der asymmetrischen Signalverzögerung zunächst eine steigende Signalflanke und anschließend eine fallende Signalflanke an, wobei das externe Testgerät die jeweilige Durchlaufzeit für die steigende Signalflanke und die Durchlaufzeit für die fallende Signalflanke erfasst, wobei die asymmetrische Signalverzögerung als Differenz der Durchlaufzeit für die steigende Signalflanke und der Durchlaufzeit für die fallende Signalflanke berechnet wird.

Bei einer Ausführungsform des erfindungsgemäßen Verfahrens wird der Multiplexer zwischen einem ersten Messbetriebsmodus zum Messen der Signalverzögerung des Messpfades und einem zweiten Messbetriebsmodus zur Messung der Signalverzögerung des Multiplexers umgeschaltet.

Bei einer Ausführungsform des erfindungsgemäßen Verfahrens schaltet der Multiplexer in einem Normalbetriebsmodus ein von einer integrierten Logikschaltung abgegebenes Ausgangssignal durch.

Bei einer Ausführungsform des erfindungsgemäßen Verfahrens wird der integrierte Signalpfad durch einen Datensignalpfad gebildet, der in einem Normalbetriebsmodus ein Signal an ein integriertes flankengetriggertes Flipflop abgibt.

Bei einer Ausführungsform des erfindungsgemäßen Verfahrens wird der integrierte Signalpfad durch einen Taktsignalpfad gebildet, der in dem Normalbetriebsmodus ein Taktsignal an einen Taktsignaleingang eines integrierten flankengesteuerten Flipflops abgibt.

Bei einer Ausführungsform des erfindungsgemäßen Verfahrens schaltet eine Betriebsmodussteuereinheit den Multiplexer zwischen dem ersten Messbetriebsmodus, dem zweiten Messbetriebsmodus und dem Normalbetriebsmodus um.

Bei einer Ausführungsform des erfindungsgemäßen Verfahrens wird das flankengetriggerte Flipflop durch ein D-Flipflop gebildet, das ein logisches Ausgangssignal an einen integrierten Decoder der einer integrierten Schaltung abgibt.

Die Erfindung schafft ferner eine integrierte Schaltung, die mindestens einen integrierten Signalpfad mit messbarer asymmetrischer Signalverzögerung aufweist, wobei in einem ersten Messbetriebsmodus ein Ausgangssignal des integrierten Signalpfades mittels eines steuerbaren integrierten Multiplexers zur Messung einer asymmetrischen Signalverzögerung eines Messpfades, der den integrierten Signalpfad und den integrierten Multiplexer umfasst, auskoppelbar ist, wobei in einem zweiten Messbetriebsmodus ein Messsignal mittels des steuerbaren integrierten Multiplexers zur Messung der asymmetrischen Signalverzögerung des integrierten Multiplexers auskoppelbar ist.

Bei einer bevorzugten Ausführungsform der integrierten Schaltung weist der Signalpfad mindestens einen Pufferschaltkreis für ein Empfangsdatensignal auf.

Bei einer bevorzugten Ausführungsform der integrierten Schaltung ist der Signalpfad ausgangsseitig an einen Dateneingang eines flankengetriggerten Flipflops angeschlossen ist, dessen Ausgang mit einem integrierten Decoder der integrierten Schaltung verbunden ist.

Bei einer bevorzugten Ausführungsform der integrierten Schaltung wird der Signalpfad durch einen integrierten Taktsignalpfad gebildet.

Bei einer bevorzugten Ausführungsform der integrierten Schaltung weist der Taktsignalpfad einen integrierten Taktgenerator zur Erzeugung eines Taktsignals auf.

Bei einer bevorzugten Ausführungsform der integrierten Schaltung ist der Taktsignalgenerator eine PLL-Schaltung.

Bei einer bevorzugten Ausführungsform der integrierten Schaltung weist der integrierte Multiplexer mindestens drei Eingänge, einen Ausgang und einen Steuereingang auf.

Bei einer bevorzugten Ausführungsform der integrierten Schaltung schaltet der Multiplexer in dem ersten Messbetriebsmodus einen mit dem ersten Eingang des Multiplexers verbundenen Ausgang des integrierten Signalpfades, in dem zweiten Messbetriebsmodus einen an den zweiten Eingang des Multiplexers angelegtes Taktsignal, und in einem Normalbetriebsmodus einen an einen dritten Eingang des Multiplexers angelegtes logisches Ausgangssignal einer integrierten Logikschaltung zu einem Ausgangssignal-Pad der integrierten Schaltung durch.

Bei einer bevorzugten Ausführungsform der integrierten Schaltung ist der Steuereingang des integrierten Multiplexers mit einer integrierten Betriebsmodussteuereinheit verbunden.

Bei einer bevorzugten Ausführungsform der integrierten Schaltung ist die integrierte Schaltung ein Kommunikations-Controller für einen FlexRay-Bus.

Im Weiteren werden bevorzugte Ausführungsformen des erfindungsgemäßen Verfahrens zur Bestimmung einer asymmetrischen Signalverzögerung eines Signalpfades innerhalb einer integrierten Schaltung unter Bezugnahme auf die beigefügten Figuren zur Erläuterung erfindungswesentlicher Merkmale beschrieben.

Es zeigen:
- Figur 1:: ein Blockschaltbild einer herkömmlichen integrierten Schaltung nach dem Stand der Technik;
- Figur 2:: ein Blockschaltbild eines herkömmlichen Kommunikationsbausteins nach dem Stand der Technik;
- Figur 3:: ein Blockschaltbild einer Testanordnung zur Bestimmung einer asym- metrischen Signalverzögerung eines Signalpfades innerhalb einer in- tegrierten Schaltung gemäß einer erfindungsgemäßen Ausführungs- form;
- Figur 4:: ein Ablaufdiagramm einer möglichen Ausführungsform des erfindungs- gemäßen Verfahrens zur Bestimmung einer asymmetrischen Signal- verzögerung eines Signalpfades innerhalb einer integrierten Schaltung;
- Figur 5:: ein Blockschaltbild eines Kommunikationsbausteins als Ausführungs- beispiel für die erfindungsgemäße integrierte Schaltung;
- Figur 6:: ein Signaldiagramm zur Erläuterung eines Messvorgangs zur Bestim- mung einer asymmetrischen Signalverzögerung gemäß dem erfin- dungsgemäßen Verfahren;
- Figuren 7A, 7B:: mögliche Ausführungsformen des bei der erfindungsgemäßen integ- rierten Schaltung eingesetzten Multiplexers.

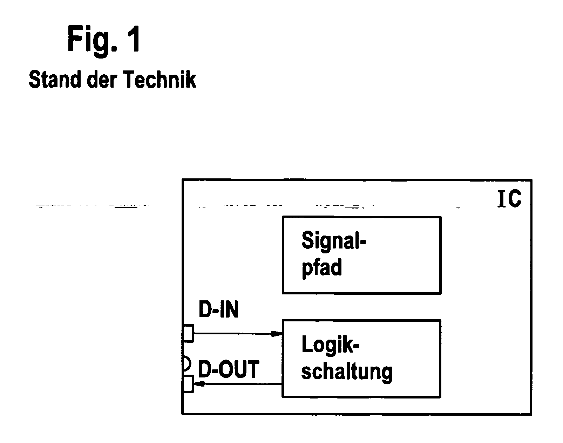

Figur 1 zeigt eine integrierte Schaltung nach dem Stand der Technik, welche einen beliebigen integrierten Signalpfad, beispielsweise einen Datensignalpfad oder einen Taktsignalpfad und eine integrierte Logikschaltung aufweist. Die Logikschaltung wird über mindestens ein Datensignaleingangs-Pin bzw. ein Datensignaleingangs-Pad (D-IN) ein logisches Dateneingangssignal empfangen, welches durch die Logikschaltung verarbeitet wird. Die Logikschaltung gibt ein dementsprechendes logisches Datenausgangssignal über ein Datensignalausgangs-Pad (D-OUT) ab.

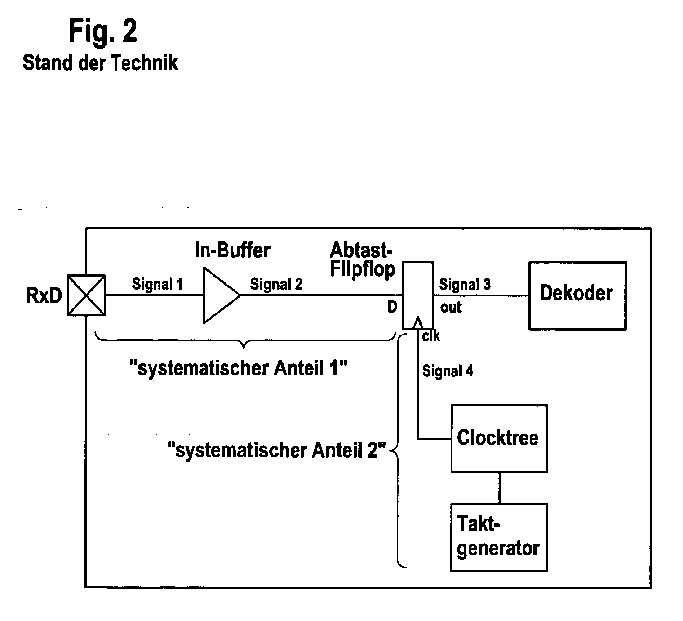

Figur 2 zeigt ein Beispiel für eine derart integrierte Schaltung nach dem Stand der Technik. Bei der in Figur 2 dargestellten herkömmlichen integrierten Schaltung handelt es sich um einen Kommunikationskontrollbaustein, beispielsweise für einen FlexRay-Bus. An einem Eingangssignal-Pin bzw. einem Eingangssignal-Pad RxD wird ein Datensignal empfangen und über einen Eingangssignaldatenpuffer an den Dateneingang D eines Abtast-Flipflops, beispielsweise an den Dateneingang eines D-Flipflops angelegt. Das flankengetriggerte Abtast-Flipflop erhält über einen Taktsignaleingang ein Taktsignal von einem Taktsignalpfad, der einen Taktsignalgenerator, beispielsweise eine PLL-Schaltung, enthält, die ein Taktsignal erzeugt. Das erzeugte Taktsignal CLK wird beispielsweise baumförmig über Taktsignalleitungen der integrierten Schaltung verteilt und gelangt zu dem Takteingang des Abtast-Flipflops. Das Abtast-Flipflop tastet das empfangene Datensignal ab und gibt ein abgetastetes logisches Datensignal an einen nachgeschalteten Decoder ab. Die Taktversorgung des Abtast-Flipflops durch den Taktsignalpfad erfolgt mit einer gewissen Ungenauigkeit, insbesondere aufgrund des Phasenjitters des durch die PLL-Schaltung erzeugten Taktsignals CLK. Hinzu kommt eine asymmetrische Verzögerung, die durch baumförmige Verzweigung der Taktsignalleitungen bzw. des Clock Trees hervorgerufen wird. Diese Asymmetrie führt zu einer Abweichung von dem idealen Taktsignal CLK, d. h. zu einem sogenannten Clock Skew. Falls es sich bei dem Kommunikationskontrollbaustein gemäß Figur 2 um eine integrierte Schaltung handelt, ist lediglich die Signaleingangs-Pin RxD von außen zugänglich. Die Taktversorgung sowie weitere Asymmetrie verursachende Baukomponenten des Kommunikationsbausteins sind ebenfalls gekapselt. Der herkömmliche integrierte Kommunikationskontrollbaustein gemäß Figur 2 erlaubt somit keinen direkten Messzugriff, beispielsweise nach dem Eingangssignalpuffer zur Bestimmung der durch den Eingangssignalpuffer hervorgerufenen asymmetrischen Signalverzögerung.

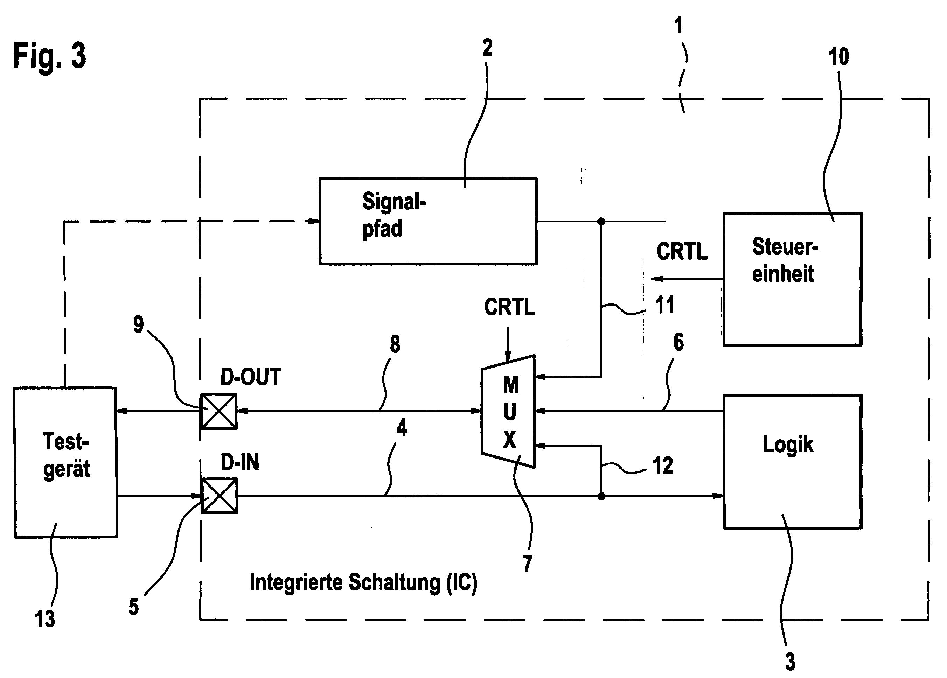

Figur 3 zeigt ein Blockschaltbild einer möglichen Ausführungsform der erfindungsgemäßen integrierten Schaltung 1. Die integrierte Schaltung 1 weist einen integrierten Signalpfad 2 mit messbarer asymmetrischer Signalverzögerung auf. Bei dem Signalpfad 2 handelt es sich beispielsweise um einen Datensignalpfad oder um einen Taktsignalpfad. Die integrierte Schaltung 1 enthält neben dem Signalpfad 2 eine Logikschaltung 3. Die Logikschaltung 3 hat mindestens einen Dateneingang, der über eine interne Datenleitung 4 mit einem Dateneingangssignal-Pad 5 der integrierten Schaltung 1 verbunden ist. Das an dem Datensignaleingangs-Pad 5 anliegende Datensignal wird durch die integrierte Logikschaltung 3 verarbeitet Das von der Logikschaltung 3 erzeugte Ausgangssignal wird über eine interne Datenleitung 6 an einen Eingang eines integrierten Multiplexers 7 abgegeben. Der integrierte Multiplexer 7 weist bei einer bevorzugten Ausführungsform der integrierten Schaltung 1 drei Signaleingänge, einen Steuereingang sowie einen Ausgang auf, der, wie in Figur 3 ersichtlich, über eine interne Datenleitung 8 mit einem Datenausgangssignal-Pad 9 der integrierten Schaltung 1 verbunden ist. Das Steuersignal CTRL zur Ansteuerung des Multiplexers 7 wird durch eine integrierte Betriebsmodussteuereinheit 10 der integrierten Schaltung 1 erzeugt.

Der Multiplexer 7 ist zwischen seinen drei Signaleingängen umschaltbar. In einem ersten Messbetriebsmodus MBI der integrierten Schaltung 1 wird ein Signalausgang des Signalpfades 2 über eine interne Leitung 11 und einen ersten Signaleingang des Multiplexers 7 an das Datensignalausgangs-Pad 9 der integrierten Schaltung 1 durchgeschaltet. In einem zweiten Messbetriebsmodus MBII wird ein an dem Datensignaleingang 5 anliegendes Messsignal über eine interne Datenleitung 12 und einen zweiten Signaleingang des Multiplexers 7 an das Datensignalausgangs-Pad 9 der integrierten Schaltung 1 durchgeschaltet. In einem Normalbetriebsmodus NB der integrierten Schaltung 1 wird das von der Logikschaltung 3 abgegebene logische Ausgangssignal über den dritten Eingang des Multiplexers 7 an das Datensignalausgangs-Pad 9 der integrierten Schaltung 1 durchgeschaltet.

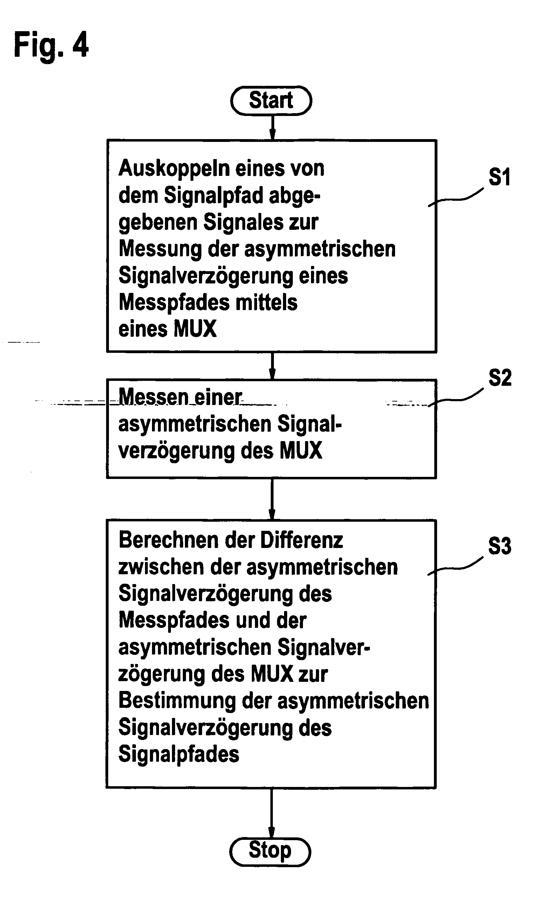

Figur 4 zeigt ein Ablaufdiagramm zur Darstellung einer möglichen Ausführungsform des erfindungsgemäßen Verfahrens zur Bestimmung einer asymmetrischen Signalverzögerung des in Figur 3 dargestellten internen Signalpfades 2 der integrierten Schaltung 1. In einem ersten Schritt S1 schaltet die Steuereinheit 10 den Ausgang des integrierten Signalpfades 2 an das Datensignalausgangs-Pad 9 durch Ansteuerung des Multiplexers 7 durch, d. h. das von dem Signalpfad 2 abgegebene Signal wird mittels des integrierten Multiplexers 7 zur Messung einer asymmetrischen Signalverzögerung eines Messpfades ausgekoppelt. Der Messpfad wird dabei durch den integrierten Signalpfad 2, die interne Leitung 11, den Multiplexer 7 und durch die interne Leitung 8 gebildet. Der Messpfad enthält sowohl den integrierten Signalpfad 2 als auch den integrierten Multiplexer 7. Der Signalpfad 2 ist beispielsweise ein Datensignalpfad oder ein interner Taktsignalpfad. Handelt es sich bei dem Signalpfad um einen Datensignalpfad, legt beispielsweise ein externes Testgerät 13 zunächst eine steigende Signalflanke und anschließend eine fallende Signalflanke an einen Eingang des integrierten Datensignalpfades 2 der integrierten Schaltung 1 an. Das externe Testgerät 13 misst eine Signalverzögerung, die durch den Messpfad, d. h. durch den Signalpfad 2 und den Multiplexer 7 hervorgerufen wird, sowohl für eine steigende Signalflanke als auch für eine fallende Signalflanke des Messsignals. Die asymmetrische Signalverzögerung des Messpfades, der den integrierten Signalpfad 2 und den integrierten Multiplexer 7 umfasst, wird durch das Testgerät 3 als Differenz zwischen der gemessenen Durchlaufzeit für die steigende Signalflanke und der gemessenen Durchlaufzeit für die fallende Signalflanke ermittelt bzw. berechnet.

Handelt es sich bei einer alternativen Ausführungsform der integrierten Schaltung 1 bei dem Signalpfad 2 um einen internen Taktsignalpfad, wird durch das externe Testgerät 13 kein Messsignal an den Signalpfad 2 angelegt, da der Signalpfad 2 selbst ein Taktsignal CLK generiert. In beiden Fällen wird durch den Multiplexer 7 zunächst das von dem Signalpfad 2, d. h. von dem Datensignalpfad oder dem Taktsignalpfad, abgegebene Signal zur Messung der asymmetrischen Signalverzögerung des Messpfades über das Datensignalausgangs-Pad 9 an das externe Testgerät 13 ausgekoppelt, welches die asymmetrische Signalverzögerung des Messpfades ermittelt.

Der Multiplexer 7 weist als integriertes Bauelement selbst eine asymmetrische Signalverzögerung auf. Da nicht bekannt ist, ob die Asymmetrie des Multiplexers die Asymmetrie des Signalpfades 2 entweder teilweise kompensiert oder vergrößert, wird bei dem erfindungsgemäßen Verfahren in einem weiteren Schritt S2 die asymmetrische Signalverzögerung des Multiplexers 7 gemessen. Hierzu schaltet die Steuereinheit 10 das an dem Datensignaleingangs-Pad 5 anliegende Messsignal durch entsprechende Ansteuerung des Multiplexers 7 an das Datensignalausgangs-Pad 9 zur Auswertung durch das Testgerät 13 durch.

In einem weiteren Schritt S3 berechnet das Testgerät 13 die Differenz zwischen der asymmetrischen Signalverzögerung des Messpfades und der asymmetrischen Signalverzögerung des integrierten Multiplexers 7. Die berechnete Differenz entspricht der asymmetrischen Signalverzögerung des integrierten Signalpfades 2.

Damit im zweiten Messvorgang die ermittelte Asymmetrie des Multiplexers 7 von der im ersten Messvorgang ermittelten Asymmetrie des Messpfades, welcher den Signalpfad 2 und den Multiplexer 7 umfasst, subtrahiert werden kann, ist es notwendig, dass die Asymmetrie des Multiplexers 7 für beide Messvorgänge gleich groß ist. Um dies zu erreichen, ist bei einer bevorzugten Ausführungsform der erfindungsgemäßen integrierten Schaltung der Multiplexer 7 symmetrisch in Schaltung und Layout dimensioniert. Vorzugsweise wird der Multiplexer 7 in seiner lateralen Ausdehnung bezogen auf das Chip-Layout möglichst klein ausgelegt, sodass sich der Multiplexer 7 hinsichtlich seiner asymmetrischen Verzögerungszeiten für beide Vorgänge nahezu gleich verhält.

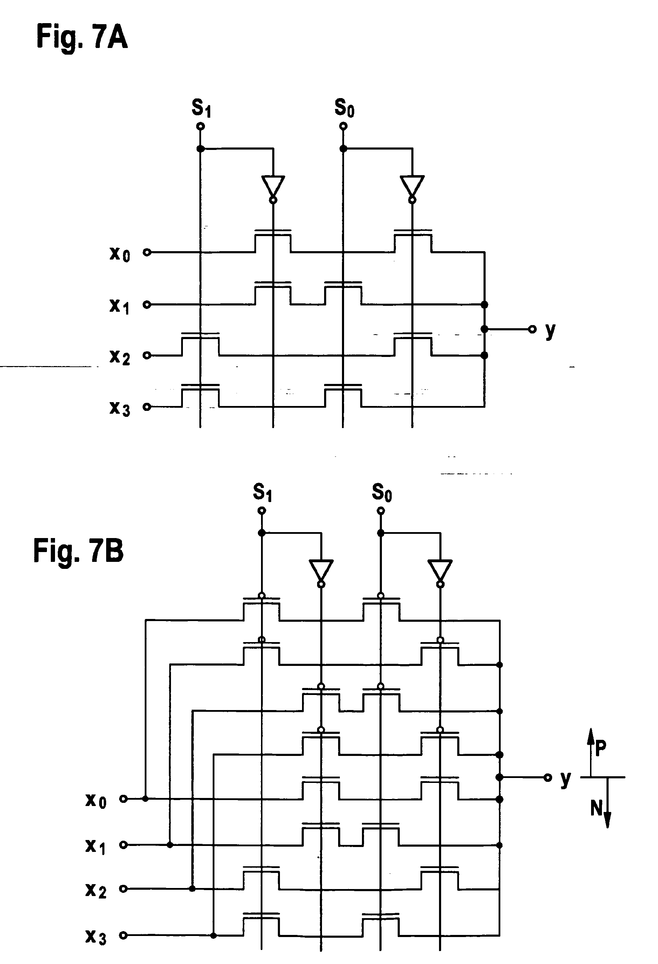

Die Figuren 7A, 7B zeigen mögliche Ausführungsformen des Multiplexers 7. Über Steuereingänge S0 bzw. S1 wird ein Pfad von den Eingängen X0, X1, X2 und X3 zu dem Ausgang Y durchgeschaltet. Bei der in Figur 7A dargestellten Ausführungsform enthält der Multiplexer NMOS-Transistoren. Bei der in Figur 7B dargestellten Ausführungsform handelt es sich um eine CMOS-Implementierung des Multiplexers 7.

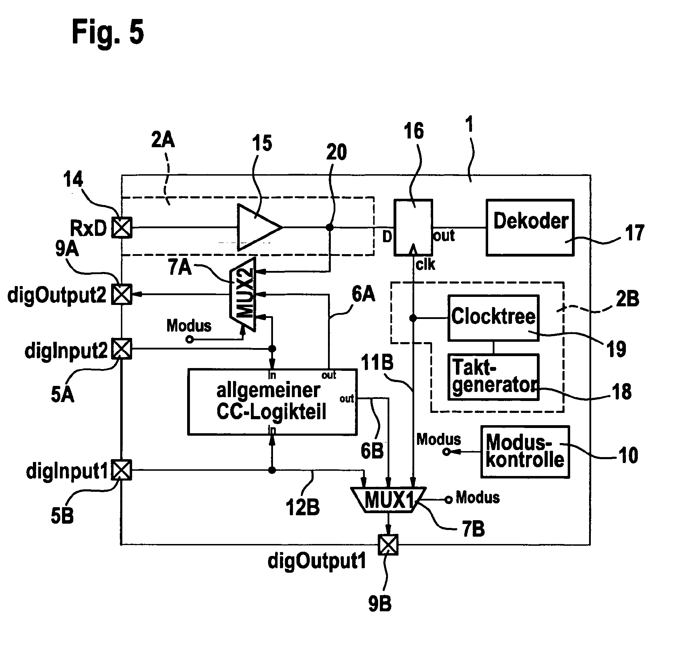

Die Figur 5 zeigt ein Ausführungsbeispiel für eine integrierte Schaltung 1 gemäß der Erfindung. Bei dem in Figur 5 dargestellten Ausführungsbeispiel wird die integrierte Schaltung 1 durch einen Kommunikationsbaustein bzw. durch einen Kommunikations-Controller für einen FlexRay-Bus gebildet. Der Kommunikationskontrollbaustein 1 gemäß Figur 5 weist neben einer integrierten Logikschaltung 3 zwei integrierte Signalpfade 2A, 2B auf, wobei der erste integrierte Signalpfad 2A durch einen integrierten Datensignalpfad gebildet und der zweite integrierte Signalpfad 2B durch einen internen Taktsignalpfad gebildet wird. Jeder der beiden integrierten Signalpfade 2A, 2B weist eine asymmetrische Signalverzögerung bzw. Taktjitter auf, die bei der erfindungsgemäßen integrierten Schaltung 1 gemäß Figur 5 messbar sind. Dabei ist ein Ausgangssignal des jeweiligen integrierten Signalpfades 2A, 2B jeweils mittels eines zugehörigen steuerbaren integrierten Multiplexers 7A, 7B, die durch eine integrierte Steuereinheit 10 angesteuert werden, zur Messung einer asymmetrischen Signalverzögerung eines Messpfades, welcher durch den jeweiligen integrierten Signalpfad 2A, 2B und den jeweiligen integrierten Multiplexer 7A, 7B gebildet wird, in einem ersten Messbetriebsmodus MBI auskoppelbar. Der in Figur 5 dargestellte Kommunikationskontrollbaustein 1 weist einen Datensignalpfad 2A auf, der ein zu verarbeitendes logisches Datensignal über ein Empfangssignal-Pad 14 erhält. Der Datensignalpfad 2A enthält mindestens einen seriell verschalteten Puffer 15, der ausgangsseitig mit einem Dateneingang D eines flankengetriggerten Abtast-Flipflops 16 verbunden ist. Das flankengetriggerte Flipflop 16 weist einen Taktsignaleingang auf, der mit dem Taktsignalpfad 2B der integrierten Schaltung 1 verbunden ist Das flankengetriggerte Flipflop 16 wird beispielsweise durch ein D-Flipflop gebildet, dessen Signalausgang mit einem integrierten Decoder 17 zur Dekodierung des an dem Datensignaleingangs-Pad 14 angelegten Datenbitstroms vorgesehen ist. Die Taktversorgung des Abtast-Flipflops 16 erfolgt durch den Taktsignalpfad 2B, der einen integrierten Taktgenerator 18, beispielsweise eine PLL-Schaltung enthält. Das von der PLL-Schaltung 18 erzeugte Taktsignal wird innerhalb der integrierten Schaltung 1 über Taktleitungen eines Taktsignalleitungsbaumes 19 verteilt und an den Taktsignaleingang des Abtast-Flipflops 16 angelegt.

Zur Bestimmung der asymmetrischen Anteile des in Figur 5 dargestellten Kommunikationskontrollbausteins 1 wird sowohl die asymmetrische Signalverzögerung des Signalpfades 2A als auch die asymmetrische Signalverzögerung des Signalpfades 2B bestimmt. Die Bestimmung der beiden asymmetrischen Signalverzögerungen kann gleichzeitig oder sequentiell durch ein externes Testgerät 13 erfolgen.

Das externe Testgerät 13 misst zunächst die asymmetrische Signalverzögerung des Signalpfades 2A durch Auskoppeln eines angelegten Messsignals an einem Abgriffknoten 20 und durch anschließende Messung der asymmetrischen Signalverzögerung des integrierten Multiplexers 7A, indem ein Messsignal an das Datensignaleingangs-Pad 5A angelegt wird und über das Datensignalausgangs-Pad 9A ausgelesen wird. Die asymmetrische Signalverzögerung des Signalpfades 2A wird dann durch Berechnung der Differenz zwischen der gemessenen asymmetrischen Signalverzögerung des Messpfades, der den integrierten Datensignalpfad 2A und den integrierten Multiplexer 7A umfasst, und der gemessenen asymmetrischen Signalverzögerung des integrierten Multiplexers 7A selbst, bestimmt.

In gleicher Weise wird anschließend bzw. parallel die Signalverzögerung des Taktsignalpfades 2B bestimmt, indem an einem Abgriffknoten 21 das von dem Taktsignalpfad 2B erzeugte und verteilte Taktsignal CLK vor dem Takteingang des Abtast-Flipflops 16 über den Multiplexer 7B an das Datensignalausgangs-Pad 9B der integrierten Schaltung 1 ausgekoppelt wird. Anschließend erfolgt wiederum eine Messung der asymmetrischen Signalverzögerung des integrierten Multiplexers 7B selbst, indem ein Messsignal an dem Datensignaleingangs-Pad 5B anlegt und an dem Datensignalausgangs-Pad 9B ausgelesen wird.

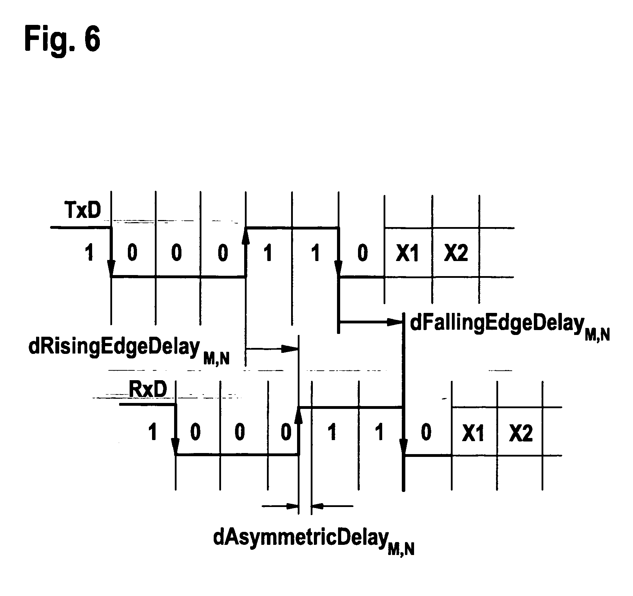

Figur 6 verdeutlicht die Messung der asymmetrischen Signalverzögerung zur Messung der Differenz der Durchlaufzeit für eine fallende und steigende Signalflanke eines Messsignals.

Die asymmetrische Verzögerung des in Figur 5 dargestellten Kommunikationsbausteins setzt sich hauptsächlich aus zwei systematischen Anteilen zusammen. Der erste systematische Anteil wird durch die asymmetrische Verzögerung von dem Eingangssignal-Pin RxD bis hin zum Dateneingang des Abtast-Flipflops 16 gebildet.

Der zweite systematische Anteil weist den Taktsignaljitter an dem Taktsignaleingang des Abtast-Flipflops 16 auf, d. h. die Abweichung von dem idealen Takt hinsichtlich der Periodendauer. Der Taktsignaljitter setzt sich aus dem Jitter der Taktquelle, d. h. des Taktgenerators 18, beispielsweise eines Quarzes oder einer PLL-Schaltung, sowie asymmetrische Verzögerungen des Taktsignalbaumes zusammen. Der Taktsignalbaum wird durch eine kaskadierte baumförmige Pufferschaltung gebildet, die der begrenzten Treiberfähigkeit des Taktgenerators 18 Rechnung trägt und eine ausgeglichene Taktversorgung aller Flipflops innerhalb der integrierten Schaltung 1 sicherstellt.

Bei der erfindungsgemäßen integrierten Schaltung 1 wird mittels Multiplexer 7A, 7B über die ohnehin vorhandenen digitalen Eingangs- und Ausgangssignal-Pins 5A, 5B, 9A, 9B die Messung der systematischen Anteile der asymmetrischen Signalverzögerung ermöglicht, wobei die asymmetrischen Anteile, die durch die Multiplexer 7A, 7B selbst hervorgerufen werden, in einem zusätzlichen Messschritt S2 ermittelt und anschließend in einem Schritt S3 herausgerechnet werden. Die erfindungsgemäße integrierte Schaltung 1 und das erfindungsgemäße Verfahren erlauben es, ohne Verwendung zusätzlicher Pads die asymmetrische Verzögerung in dem Kommunikationskontrollbaustein 1 gemäß Figur 5 zu bestimmen.

Vorzugsweise werden zum Messen der Asymmetrie die Signale mit definierter Bitdauer angelegt und die resultierende Bitdauer gemessen. Die Differenz zwischen der angelegten Bitdauer und der gemessenen Bitdauer entspricht der asymmetrischen Signalverzögerung. Alternativ kann die Durchlaufverzögerung einer steigenden und einer fallenden Signalflanke gemessen werden und durch die Differenzbildung die asymmetrische Verzögerung bestimmt werden.

Bei der erfindungsgemäßen integrierten Schaltung 1 kann es sich um eine beliebige integrierte Schaltung 1, beispielsweise eine anwenderspezifische integrierte Schaltung ASIC oder um eine programmierbare integrierte Logikschaltung FPGA handeln. Die erfindungsgemäße integrierte Schaltung 1 erlaubt mit einem sehr geringen zusätzlichen schaltungstechnischen Aufwand, d. h. durch Vorsehen eines zusätzlichen Multiplexers pro Signalpfad, eine Ermittlung der asymmetrischen Signalverzögerung des jeweiligen Signalpfades.

Das erfindungsgemäße Verfahren zur Bestimmung der asymmetrischen Signalverzögerung und des Signalpfades kann sowohl in einer Designphase bei der Entwicklung von integrierten Chips 1 als auch bei der Herstellung von integrierten Chips 1 zur Qualitätssicherung, aber auch im laufenden Betrieb des integrierten Chips 1 durchgeführt werden.

## Patentansprüche

1. Verfahren zur Bestimmung einer asymmetrischen Signalverzögerung eines Signalpfades (2) innerhalb einer integrierten Schaltung (1) mit den folgenden Schritten:
(a) Auskoppeln (S1) eines von dem Signalpfad (2) abgegebenen Signals mittels eines integrierten Multiplexers (7) zur Messung einer asymmetrischen Signalverzögerung eines Messpfades, der durch den integrierten Signalpfad (2) und durch den integrierten Multiplexer (7) gebildet wird;
(b) Messen (2) einer asymmetrischen Signalverzögerung des integrierten Multiplexers (7); und
(c) Berechnen (S3) einer Differenz zwischen der asymmetrischen Signalverzögerung des Messpfades und der asymmetrischen Signalverzögerung des integrierten Multiplexers (7) zur Bestimmung der asymmetrischen Signalverzögerung des Signalpfades (2).

2. Verfahren nach Anspruch 1,
wobei ein externes Testgerät (13) zur Messung der asymmetrischen Signalverzögerung zunächst eine steigende Signalflanke und anschließend eine fallende Signalflanke anlegt,
wobei das externe Testgerät (13) die Durchlaufzeit für die steigende Signalflanke und die Durchlaufzeit für die fallende Signalflanke erfasst und die asymmetrische Signalverzögerung als Differenz zwischen der Durchlaufzeit für die steigende Signalflanke und der Durchlaufzeit für die fallende Signalflanke berechnet.

3. Verfahren nach Anspruch 1,
wobei der integrierte Multiplexer (7) zwischen einem ersten Messbetriebsmodus (MBI) zum Messen der Signalverzögerung des Messpfades und einem zweiten Messbetriebsmodus (MBII) zum Messen der Signalverzögerung des Multiplexers (7)umschaltbar ist.

4. Verfahren nach Anspruch 3,
wobei der integrierte Multiplexer (7) in einem Normalbetriebsmodus (NB) ein von einer integrierten Logikschaltung (3) erzeugtes logisches Ausgangssignal durchschaltet.

5. Verfahren nach Anspruch 4,
wobei der Signalpfad (2) durch einen Datensignalpfad (2A) gebildet wird, der in dem Normalbetriebsmodus (NB) ein Signal an ein integriertes flankengetriggertes Flipflop (16) abgibt.

6. Verfahren nach Anspruch 4,
wobei der Signalpfad (2) durch einen Taktsignalpfad (2B) gebildet wird, der in dem
Normalbetriebsmodus (NB) ein Taktsignal an einen Takteingang des integrierten flankengetriggerten Flipflops (16) abgibt.

7. Verfahren nach Anspruch 3 oder 4,
wobei eine Betriebsmodussteuereinheit (10) den Multiplexer (7) zwischen dem ersten Messbetriebsmodus (MBI), dem zweiten Messbetriebsmodus (MBII) und zwischen dem Normalbetriebsmodus (NB) umschaltet.

8. Verfahren nach Anspruch 6,
wobei das flankengetriggerte Flipflop (16) durch ein D-Flipflop gebildet wird, das ein logisches Ausgangssignal an einen integrierten Decoder (17) der integrierten Schaltung (1) abgibt.

9. Vorrichtung, die mindestens einen integrierten Signalpfad 2 mit messbarer asymmetrischer Signalverzögerung aufweist,
wobei in einem ersten Messbetriebsmodus (MBI) ein Ausgangssignal des integrierten Signalpfades (2) mittels eines steuerbaren integrierten Multiplexers (7) zur Messung einer asymmetrischen Signalverzögerung eines Messpfades, der den integrierten Signalpfad (2) und den integrierten Multiplexer (7) umfasst, auskoppelbar ist,
wobei in einem zweiten Messbetriebsmodus (MBII) ein Messsignal mittels des steuerbaren integrierten Multiplexers (7) zur Messung der asymmetrischen Signalverzögerung des integrierten Multiplexers (7) auskoppelbar ist.

10. Vorrichtung nach Anspruch 9,
wobei der Signalpfad (2) mindestens einen Pufferschaltkreis (15) für ein Empfangsdatensignal aufweist.

11. Vorrichtung nach Anspruch 10,
wobei der Signalpfad (2) ausgangsseitig an einen Dateneingang eines flankengetriggerten Flipflops (16) angeschlossen ist, dessen Ausgang mit einem integrierten Decoder (17) verbunden ist.

12. Vorrichtung nach Anspruch 9,
wobei der Signalpfad (2) durch einen integrierten Taktsignalpfad (2B) gebildet wird.

13. Vorrichtung nach Anspruch 12,
wobei der Taktsignalpfad einen integrierten Taktgenerator zur Erzeugung eines Taktsignals aufweist.

14. Vorrichtung nach Anspruch 13,
wobei der Taktsignalgenerator (18) eine PLL-Schaltung ist.

15. Vorrichtung nach Anspruch 9,
wobei der integrierte Multiplexer (7) mindestens drei Eingänge, einen Ausgang und einen Steuereingang aufweist.

16. Vorrichtung nach Anspruch 15,
wobei der Multiplexer (7) in dem ersten Messbetriebsmodus (MBI) einen mit einem ersten Eingang des Multiplexers (7) verbundenen Ausgang des integrierten Signalpfades (2),
in dem zweiten Messbetriebsmodus (MBII) ein an einem zweiten Eingang des Multiplexers (7) angelegtes Messsignal, und
in einem Normalbetriebsmodus (NB) einen an einen dritten Eingang des Multiplexers (7) angelegtes logisches Ausgangssignal einer integrierten Logikschaltung (3) zu einem Ausgangssignal-Pad (5) der Vorrichtung (1) durchschaltet.

17. Vorrichtung nach Anspruch 15,
wobei der Steuereingang des integrierten Multiplexers (7) mit einer integrierten Betriebsmodussteuereinheit (10) verbunden ist.

18. Vorrichtung nach Anspruch 9,
wobei die Vorrichtung (1) ein Kommunikations-Controller für einen FlexRay-Bus ist.

## Claims

1. Method for determining an asymmetrical signal delay of a signal path (2) inside an integrated circuit (1), having the following steps of:
(a) outputting (S1) a signal emitted by the signal path (2) by means of an integrated multiplexer (7) for measuring an asymmetrical signal delay of a measuring path formed by the integrated signal path (2) and the integrated multiplexer (7);
(b) measuring (S2) an asymmetrical signal delay of the integrated multiplexer (7); and
(c) calculating (S3) a difference between the asymmetrical signal delay of the measuring path and the asymmetrical signal delay of the integrated multiplexer (7) in order to determine the asymmetrical signal delay of the signal path (2).

2. Method according to Claim 1,
an external test device (13) first of all applying a rising signal edge and then applying a falling signal edge in order to measure the asymmetrical signal delay,
the external test device (13) detecting the transit time for the rising signal edge and the transit time for the falling signal edge and calculating the asymmetrical signal delay as the difference between the transit time for the rising signal edge and the transit time for the falling signal edge.

3. Method according to Claim 1,
the integrated multiplexer (7) being able to be changed over between a first measurement operating mode (MBI) for measuring the signal delay of the measuring path and a second measurement operating mode (MBII) for measuring the signal delay of the multiplexer (7).

4. Method according to Claim 3,
the integrated multiplexer (7) switching through a logical output signal generated by an integrated logic circuit (3) in a normal operating mode (NB).

5. Method according to Claim 4,
the signal path (2) being formed by a data signal path (2A) which emits a signal to an integrated edge-triggered flip-flop (16) in the normal operating mode (NB).

6. Method according to Claim 4,
the signal path (2) being formed by a clock signal path (2B) which emits a clock signal to a clock input of the integrated edge-triggered flip-flop (16) in the normal operating mode (NB).

7. Method according to Claim 3 or 4,
an operating mode control unit (10) changing over the multiplexer (7) between the first measurement operating mode (MBI), the second measurement operating mode (MBII) and the normal operating mode (NB).

8. Method according to Claim 6,
the edge-triggered flip-flop (16) being formed by a D-type flip-flop which emits a logical output signal to an integrated decoder (17) of the integrated circuit (1).

9. Apparatus which has at least one integrated signal path (2) with a measurable asymmetrical signal delay,
an output signal from the integrated signal path (2) being able to be output in a first measurement operating mode (MBI) by means of a controllable integrated multiplexer (7) for measuring an asymmetrical signal delay of a measuring path which comprises the integrated signal path (2) and the integrated multiplexer (7),
a measurement signal being able to be output in a second measurement operating mode (MBII) by means of the controllable integrated multiplexer (7) for measuring the asymmetrical signal delay of the integrated multiplexer (7).

10. Apparatus according to Claim 9,
the signal path (2) having at least one buffer circuit (15) for a received data signal.

11. Apparatus according to Claim 10,
the signal path (2) being connected, on the output side, to a data input of an edge-triggered flip-flop (16) whose output is connected to an integrated decoder (17).

12. Apparatus according to Claim 9,
the signal path (2) being formed by an integrated clock signal path (2B).

13. Apparatus according to Claim 12,
the clock signal path having an integrated clock generator for generating a clock signal.

14. Apparatus according to Claim 13,
the clock signal generator (18) being a PLL circuit.

15. Apparatus according to Claim 9,
the integrated multiplexer (7) having at least three inputs, one output and one control input.

16. Apparatus according to Claim 15,
the multiplexer (7) switching through an output of the integrated signal path (2), which is connected to a first input of the multiplexer (7), to an output signal path (5) of the apparatus (1) in the first measurement operating mode (MBI),
the multiplexer (7) switching through a measurement signal applied to a second input of the multiplexer (7) to an output signal path (5) of the apparatus (1) in the second measurement operating mode (MBII), and
the multiplexer (7) switching through a logical output signal from an integrated logic circuit (3), which is applied to a third input of the multiplexer (7), to an output signal path (5) of the apparatus (1) in a normal operating mode (NB).

17. Apparatus according to Claim 15,
the control input of the integrated multiplexer (7) being connected to an integrated operating mode control unit (10).

18. Apparatus according to Claim 9,
the apparatus (1) being a communication controller for a FlexRay bus.

## Revendications

1. Procédé pour déterminer un retard de signal asymétrique d'un trajet de signal (2) à l'intérieur d'un circuit intégré (1), comprenant les étapes suivantes :
(a) Découplage (S1) d'un signal délivré par le trajet de signal (2) au moyen d'un multiplexeur (7) intégré pour mesurer un retard de signal asymétrique d'un trajet de mesure qui est formé par le trajet de signal (2) intégré et par le multiplexeur (7) intégré ;
(b) Mesure (2) d'un retard de signal asymétrique du multiplexeur (7) intégré ; et
(c) Calcul (S3) d'une différence entre le retard de signal asymétrique du trajet de mesure et le retard de signal asymétrique du multiplexeur (7) intégré pour déterminer le retard de signal asymétrique du trajet du signal (2).

2. Procédé selon la revendication 1,
selon lequel un appareil de test externe (13) destiné à mesurer le retard de signal asymétrique applique tout d'abord un front de signal montant et ensuite un front de signal descendant,
selon lequel l'appareil de test externe (13) détecte le temps de passage du front de signal montant et le temps de passage du front de signal descendant et calcule le retard de signal asymétrique sous la forme de la différence entre le temps de passage du front de signal montant et le temps de passage du front de signal descendant.

3. Procédé selon la revendication 1,
selon lequel le multiplexeur (7) intégré peut être commuté entre un premier mode de fonctionnement en mesure (MBI) pour mesurer le retard du signal du trajet de mesure et un deuxième mode de fonctionnement en mesure (MBII) pour mesurer le retard du signal du multiplexeur (7).

4. Procédé selon la revendication 3,
selon lequel le multiplexeur (7) intégré, dans un mode de fonctionnement normal (NB), commute un signal de sortie logique généré par un circuit logique (3) intégré.

5. Procédé selon la revendication 4,
selon lequel le trajet du signal (2) est formé par un trajet de signal de données (2A) qui, dans le mode de fonctionnement normal (NB), délivre un signal à une bascule bistable (16) à déclenchement par front intégrée.

6. Procédé selon la revendication 4,
selon lequel le trajet du signal (2) est formé par un trajet de signal d'horloge (2B) qui, dans le mode de fonctionnement normal (NB), délivre un signal d'horloge à une entrée d'horloge de la bascule bistable (16) à déclenchement par front intégrée.

7. Procédé selon la revendication 3 ou 4,
selon lequel une unité de contrôle du mode de fonctionnement (10) permute le multiplexeur (7) entre le premier mode de fonctionnement en mesure (MBI), le deuxième mode de fonctionnement en mesure (MBII) et le mode de fonctionnement normal (NB).

8. Procédé selon la revendication 6,
selon lequel la bascule bistable (16) à déclenchement par front est formée par une bascule bistable D qui délivre un signal de sortie logique à un décodeur intégré (17) du circuit intégré (1).

9. Dispositif qui présente au moins un trajet de signal (2) intégré avec retard de signal asymétrique mesurable,
avec lequel, dans un premier mode de fonctionnement en mesure (MBI), un signal de sortie du trajet de signal (2) intégré peut être découplé au moyen d'un multiplexeur (7) intégré commandable pour mesurer un retard de signal asymétrique d'un trajet de mesure qui comprend le trajet de signal (2) intégré et le multiplexeur (7) intégré,
avec lequel, dans un deuxième mode de fonctionnement en mesure (MBII), un signal de mesure peut être découplé au moyen du multiplexeur (7) intégré commandable pour mesurer le retard de signal asymétrique du multiplexeur (7) intégré.

10. Dispositif selon la revendication 9,
avec lequel le trajet de signal (2) présente au moins un circuit tampon (15) pour un signal de données de réception.

11. Dispositif selon la revendication 10,
avec lequel le trajet de signal (2) est raccordé du côté de la sortie à une entrée de données d'une bascule bistable (16) à déclenchement par front dont la sortie est reliée à un décodeur (17) intégré.

12. Dispositif selon la revendication 9,
avec lequel le trajet de signal (2) est formé par un trajet de signal d'horloge (2B) intégré.

13. Dispositif selon la revendication 12,
avec lequel le trajet de signal d'horloge présente un générateur d'horloge intégré pour générer un signal d'horloge.

14. Dispositif selon la revendication 13,
avec lequel le générateur de signal d'horloge (18) est un circuit PLL.

15. Dispositif selon la revendication 9,
avec lequel le multiplexeur (7) intégré présente au moins trois entrées, une sortie et une entrée de commande.

16. Dispositif selon la revendication 15,
avec lequel le multiplexeur (7) intégré, dans le premier mode de fonctionnement en mesure (MBI), commute une sortie du trajet de signal (2) intégré reliée avec une première entrée du multiplexeur (7),
dans le deuxième mode de fonctionnement en mesure (MBII), commute un signal de mesure appliqué à une deuxième entrée du multiplexeur (7), et
dans un mode de fonctionnement normal (NB), commute un signal de sortie logique d'un circuit logique (3) intégré, appliqué à une troisième entrée du multiplexeur (7), avec un trajet de signal de sortie (5) du dispositif (1).

17. Dispositif selon la revendication 15,
avec lequel l'entrée de commande du multiplexeur (7) intégré est reliée avec une unité de contrôle du mode de fonctionnement (10) intégrée.

18. Dispositif selon la revendication 9,
avec lequel le dispositif (1) est un contrôleur de communication pour un bus FlexRay.
